# EUROPÄISCHE PATENTSCHRIFT

(11) **EP 2 077 704 B1**
(45) Veröffentlichungstag und Bekanntmachung des Hinweises auf die Patenterteilung: **20.06.2012**
(21) Anmeldenummer: 08000146.4
(22) Anmeldetag: 07.01.2008
(51) Int. Cl.: H05K 7/14

(54) **Elektronische Steckbaugruppe zur Aufnahme in einen Baugruppenträger**
Electronic assembly for transport in an assembly carrier
Module électronique enfichable destiné à la réception dans un support de composants

(43) Veröffentlichungstag der Anmeldung: 08.07.2009
(73) Patentinhaber: Schroff GmbH, D-75334 Straubenhardt (DE)
(72) Erfinder: Joist, Michael, 76571 Gaggenau (DE); Weber, Rainer, 76307 Karlsbad (DE); Thalau, Klaus-Michael, 76316 Malsch (DE); Rutherford, Paul, 76228 Karlsruhe (DE)
(74) Vertreter: Petirsch, Markus

(56) Entgegenhaltungen:
- EP-A- 1 845 765
- DE-A1- 1 553 608
- DE-A1- 3 310 474
- GB-A- 909 037

## Beschreibung

Die vorliegende Erfindung betrifft eine elektronische Steckbaugruppe mit einer Leiterplatte, einer Frontplatte und einer Befestigungsvorrichtung zur Aufnahme in einen Baugruppenträger mit einer Befestigungsschiene sowie eine Befestigungsvorrichtung zur Befestigung einer Frontplatte an einen Baugruppenträger und ein Verfahren zur Befestigung einer Steckbaugruppe.

Bei modular aufgebauten elektronischen Geräten, wie beispielsweise bei Baugruppenträgern, ist es üblich, einzelne Module in Form von Steckbaugruppen auszuführen. Die Steckbaugruppen weisen meistens einen mehrpoligen Stecker an ihrer Rückseite auf, der in eine Steckeraufnahme an der "Back plane" des Baugruppenträgers eingesteckt wird. An ihrer Vorderseite haben die Steckbaugruppen meistens eine Frontplatte, die mit der Vorderseite des Baugruppenträgers bündig abschließt. Die Steckbaugruppen sind in Führungsschienen des Baugruppenträgers geführt und werden so in die Baugruppenträger hinein geschoben und aus ihm herausgezogen.

Um die Steckbaugruppen in ihrer Position zu halten, werden Sie durch geeignete Mittel an dem Baugruppenträger befestigt, um ein unbeabsichtigtes Herauslösen zu verhindern. Bei den üblichen Verriegelungen der Steckbaugruppe mittels Schrauben oder Schnellverschlüssen schlägt die Rückseite der Steckbaugruppenfrontplatte an einer Montageebene an. Beispielsweise werden die Steckbaugruppen mit einer Schraube durch die Frontplatte in eine Befestigungsschiene des Baugruppenträgers angeschraubt. Dabei wird die Frontplatte mittels der Schraube so weit an den Baugruppenträger heran gedrückt, bis die Frontplatte an einer Befestigungsschiene, die die Gewinde oder einen Gewindekanal für die Befestigungsschrauben aufweist, anliegt.

Aus dem Dokument DE 15 53 608 A ist ein Spannverschluss zur Befestigung von Einschüben in Gestellen der Nachrichtentechnik bekannt. Eine Spreizhülse und eine diese Spreizhülse spreizende Schraube müssen an dem Gestell vormontiert sein. Eine Abdeckplatte mit einer daran montierten zweiten Hülse wird über die Schraube und Spreizhülse geschoben. Dabei kann es aufgrund einer durch die Vormontage erfolgten Spreizung der Spreizhülse zu einem Blockieren der Vorrichtung kommen.

Es ist auch bekannt, Steckbaugruppen durch Hebelziehgriffe in einen Baugruppenträger einzuhebeln. Die Hebel können durch unterschiedliche Mechanismen gegen ein unbeabsichtigtes Verschwenken und damit ein unbeabsichtigtes Lösen der Steckbaugruppe gesichert werden.

Eine neue Form von Steckbaugruppen, auch Module genannt, die hauptsächlich in modernen Telekommunikationssystemen eingesetzt werden, sind nach einem von der PICMG (PCI Industrial Computer Manufacturers Group) entwickelten Standard (AMC-Standard, Advanced Mezzanine Card) entwickelt. Baugruppen dieser Spezifikation sind im Vergleich zu 19"-Baugruppen relativ klein und haben eine an der Leiterplatte vormontierte Frontplatte, die einen U-förmigen Querschnitt aufweist. Die Leiterkarten weisen an ihrem hinteren Ende eine Steckzunge (card - edge) auf.

Bei den neuen Steckbaugruppen fehlen allerdings die bisher bekannten Befestigungsflansche mit den Verriegelungselementen, da die Module auch in so genannte Carrier (Adapter) eingesetzt werden sollen, die keine korrespondierende Montageebene oder Befestigungsschiene aufweisen. Der Tiefenanschlag der Module innerhalb der Carrier erfolgt über die hintere Kante der Leiterplatte am Boden des Steckergehäuses des Carriers. Für eine sichere Kontaktübergabe der einzelnen Kontaktreihen des Steckverbinders ist der Tiefenanschlag gefordert. Der normativ spezifizierte Verriegelungsmechanismus der Module sichert deren Endposition.

Aufgrund der in der Norm festgelegten und zugelassenen Toleranzen der einzelnen Bauteile, insbesondere für die Steckbaugruppen und die Baugruppenträger, ist es nicht möglich, Befestigungsflansche an der Frontplatte vorzusehen, die an einer Befestigungsschiene des Baugruppenträgers anschlagen und auf diese Weise gleichzeitig die Kontaktierung der Steckbaugruppe mit ihrer Hinterkante sichern. Beispielsweise würde ein Festschrauben der Frontplatte an dem Baugruppenträger dazu führen, dass ein zu großer Druck des integrierten Steckers der Steckbaugruppe auf die Steckergehäuse des Baugruppenträgers ausgeübt wird. Dies könnte zu Zerstörungen führen.

Die bisher bekannten Verriegelungssysteme für solche Steckbaugruppen mit Card-Edge-Systemen sind beispielsweise in der EP 06 008 996.8 beschrieben. Durch die erhöhten Belastungen im Hinblick auf Schock- und Vibrationsfestigkeit, die in den Normen zurzeit festgelegt werden, gelangen die Befestigungssysteme an ihre Grenzen. Der an sich nahe liegende Vorschlag, die Frontplatte an der Befestigungsschiene des Baugruppenträgers anzuschrauben, scheidet aufgrund des benötigten Toleranzausgleiches aus. Wie oben bereits erwähnt, würde eine Befestigung mit Befestigungsschrauben zu Verspannungen der Leiterplatte und des Steckverbinders führen und könnte dauerhafte Beschädigungen und Funktionsstörungen hervorrufen.

Es stellt sich somit das technische Problem, die Nachteile im Stand der Technik zu überwinden und insbesondere elektronische Steckbaugruppen zuverlässig und robust in einem Baugruppenträger zu befestigen.

Gelöst wird das technische Problem durch eine elektronische Steckbaugruppe mit den Merkmalen des Anspruches 1 und durch ein Verfahren zur Befestigung einer Steckbaugruppe in einem Baugruppenträger mit den Merkmalen des Anspruches 14. Die Unteransprüche definieren bevorzugte Weiterbildungen der Erfindung.

Die erfindungsgemäße Steckbaugruppe zur Aufnahme in einen Baugruppenträger mit einer Befestigungsschiene umfasst ein Lagerteil, ein Spannteil und ein Befestigungselement. Das Lagerteil ist an der Frontplatte der Steckbaugruppe befestigt. Das Spannteil, das Befestigungselement und das Lagerteil sind kraftschlüssig derart miteinander verbunden, dass die Frontplatte in einer definierten Position relativ zu dem Baugruppenträger fixiert ist. Dabei werden auf das Lagerteil und die Frontplatte der Steckbaugruppe eine Kraft ausgeübt, die quer zur Einschubrichtung der Steckbaugruppe gerichtet ist. Eine Kraftkomponente in oder entgegen der Einschubrichtung ist vernachlässigbar.

Das (zum Beispiel zylindrische) Lagerteil hat bevorzugt eine axiale Bohrung, in die das Spannteil einsteckbar und in axialer Richtung verschiebbar ist. Eine Durchgangsbohrung des Spannteils ist vorteilhafterweise koaxial zur Bohrung des Lagerteils angeordnet. Der Begriff "Bohrung" ist im Rahmen der Erfindung so zu verstehen, dass ein Loch oder eine Öffnung, beispielsweise ein Durchgangsloch, vorhanden ist. Die Herstellung der Bohrung ist nicht auf das mechanische Bohren beschränkt. Die Bohrung muss nicht notwendigerweise rund sein, sie kann auch andere Querschnittsformen aufweisen. Das Befestigungselement einer besonderen Ausführungsform erstreckt sich durch das in dem Lagerteil steckende Spannteil und wirkt (im zusammengesetzten Zustand) mit dem Baugruppenträger zusammen. Dabei wird das bevorzugt als Schraube ausgebildete Befestigungselement in ein Gewinde in der Befestigungsschiene des Baugruppenträgers eingeschraubt.

In einer vorteilhaften Ausführungsform die Durchgangsbohrung des Spannteils an ihrer Innenseite an dem fernen, dem Baugruppenträger abgewandten Ende eine trichterförmige Aufweitung. Das Befestigungselement weist einen konischen Abschnitt auf, der mit der trichterförmigen Aufweitung des Spannteils korrespondiert. Der konische Abschnitt des Befestigungselements kann dabei eine Kraft auf die Aufweitung des Spannteils ausüben, so dass das Spannteil mit dem Befestigungselement und dem Lagerteil klemmend (kraftschlüssig) verbunden ist.

In Abhängigkeit der Toleranzen zwischen der Frontplatte der Steckbaugruppe und einer durch eine Befestigungsschiene im Frontbereich des Baugruppenträgers definierte Montageebene kann ein Spalt entstehen, wenn die Steckbaugruppe mit ihrer an ihrer Hinterkante befindlichen Steckzunge die Steckaufnahme des Baugruppenträgers sicher kontaktiert hat. Die Steckbaugruppe muss in dieser Position gehalten werden. Sie darf weder weiter in den Baugruppenträger eingeschoben noch weiter aus ihm herausgezogen werden. Der sich in dieser Endposition ergebende Spalt hat ein Spaltmaß von 0 bis ca. 1,6 Millimetern.

Um die Steckbaugruppe in dieser Endposition zu fixieren, wird erfindungsgemäß die Befestigungsvorrichtung umfassend das Lagerteil, das Spannteil und das Befestigungselement verwendet. Das Befestigungselement, das bevorzugt eine Schraube ist, ist durch das Spannteil und die Frontplatte in die Befestigungsschiene des Baugruppenträgers eingeschraubt. Beim Einschrauben übt das Befestigungselement eine Kraft auf das Spannteil derart aus, dass eine Bewegung der Frontplatte relativ zu dem Baugruppenträger unmöglich wird. Bei der Befestigung und beim Erzeugen der kraftschlüssigen Verbindung, zum Beispiel beim Einschrauben, wird eine quer zur Einschubrichtung gerichtete Kraft auf das Spannteil und/oder auf das an der Frontplatte fixierte Lagerteil ausgeübt. Der Ausdruck "quer zur Einschubrichtung" ist so zu verstehen, dass die in Einschubrichtung gerichtete Kraftkomponente deutlich kleiner ist als eine senkrecht zur Einschubrichtung orientierte Komponente, so dass keine Bewegung der Bauteile in Einschubrichtung stattfindet. Auf diese Weise wird sichergestellt, dass die Steckbaugruppe nicht an den Baugruppenträger herangedrückt wird, wodurch ein weiteres Einschieben in den Baugruppenträger verhindert wird.

Die erfindungsgemäße Befestigungsvorrichtung ist auch dazu geeignet, um Frontplatten an einem Baugruppenträger zu befestigen, die mit keiner in dem Baugruppenträger einsteckbaren Steckbaugruppe verbunden sind. Solche als Abdeckblenden dienenden Frontteile können ebenfalls mittels der Befestigungsvorrichtung direkt an dem Baugruppenträger oder mit einem kleineren gewünschten Spalt zum Baugruppenträger befestigt werden. Dadurch kann ein einheitliches Bild der Frontseite eines nur teilweise bestückten Baugruppenträgers erzeugt werden.

Im Rahmen der Erfindung hat sich herausgestellt, dass die Befestigungsvorrichtung geeignet ist, eine zuverlässige und robuste Positionierung und Fixierung an der Steckbaugruppe in dem Baugruppenträger zu gewährleisten. Auch bei Stößen mit hoher Stoßamplitude oder bei starken Vibrationen des Baugruppenträgers und/oder der Steckbaugruppe wird sie in ihrer Position in dem Baugruppenträger gehalten.

Erfindungsgemäß ist die kraftschlüssige Verbindung von Befestigungselement, Spannteil und Lagerteil derart ausgebildet, dass auf das Lagerteil eine Kraft ausgeübt wird, die quer zur Einschubrichtung der Steckbaugruppe orientiert ist. Eine Kraftkomponente in Einschubrichtung ist vernachlässigbar und führt nicht zu einer zusätzlichen Kraft auf die Leiterplatte.

Bevorzugt ist das Spannteil der Befestigungsvorrichtung als (zylindrische) Hülse oder Spreizhülse ausgebildet. Sie kann auch als Vierkant, Sechskant oder Mehrkant ausgebildet sein. Die Außenkontur des Spannteils kann an die Bohrung des Lagerteils angepasst sein, so dass eine Rotation des Spannteils in dem Lagerteil ermöglicht oder verhindert wird. An einem Ende der Spreizhülse können in ihrer Mantelfläche bevorzugt Klemmbacken, Spannzungen oder Spreizzungen ausgebildet sein, die in radialer Richtung (also quer zur Einschubrichtung) bewegbar sind. Auf diese Weise kann durch Einbringen des Befestigungselements eine Aufweitung der Spreizhülse vorgenommen werden, so dass die kraftschlüssige Verbindung zu dem Lagerteil hergestellt wird. Die Spannzungen des Spannteils sind in einer bevorzugten Ausführungsform federnd ausgebildet. Bevorzugt sind zwischen den Spannzungen Einschnitte in der Mantelfläche der Spreizhülse vorgesehen.

In einer vorteilhaften Ausführungsform ist das Lagerteil mit der Frontplatte der Steckbaugruppe einstückig verbunden. Das Lagerteil kann mit der Frontplatte verlötet, vernietet, verpresst, verschweißt oder verklebt sein. Es ist auch möglich, eine Frontplatte vorzusehen, in der das Lagerteil integriert ist, beispielsweise bei Frontplatten aus Druckguss oder aus Kunststoff.

Ein bevorzugtes Ausführungsbeispiel eines Baugruppenträgers für elektronische Steckbaugruppen mit einer Befestigungsvorrichtung für eine Frontplatte zur Befestigung der Frontplatte an dem Baugruppenträger wird nachfolgend anhand der Zeichnungen näher beschrieben. Die darin dargestellten technischen Merkmale können einzeln oder in Kombination verwendet werden, um bevorzugte Ausgestaltungen der Erfindung zu schaffen. Sie stellen keine Beschränkung der Allgemeinheit der Erfindung dar. Es zeigen:
- Figur 1: ein System mit einem Baugruppenträger mit einer Mehrzahl von Steckbaugruppen;
- Figur 2: eine Explosionszeichnung eines Teils des Systems aus Fi- gur 1;
- Figur 3: einen Querschnitt durch einen vorderen Teil des Baugruppenträgers beim Einschieben der Steckbaugruppe;
- Figur 4: einen Schnitt durch den Baugruppenträger nach Figur 3 zu Beginn des Einschraubens eines Befestigungselements;
- Figuren 5 bis 7: einen Schnitt durch den Baugruppenträger nach Figur 3 mit der in unterschiedlichen Positionen fixierten Steckbaugrup- pe; und
- Figur 8: einen Querschnitt durch ein Spannteil der Befestigungsvor- richtung.

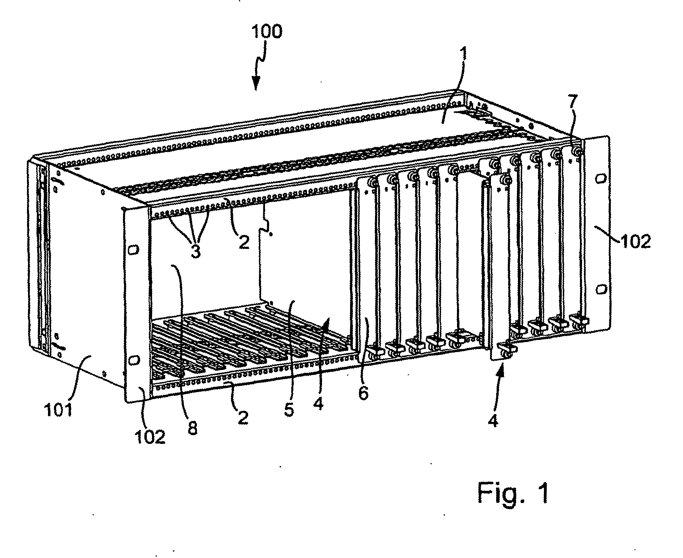

Figur 1 zeigt ein elektronisches System 100 mit einem erfindungsgemäßen Baugruppenträger 1 mit zwei Seitenwänden 101 mit je einem Anschlagwinkel 102 zur Aufnahme in einem Gehäuseschrank. Der Baugruppenträger 1 hat an seiner Frontseite zwei parallel verlaufende sich zwischen den Seitenwänden 101 erstreckende Befestigungsschienen 2, die als Lochleisten ausgeführt sind. Die Befestigungsschienen 2 weisen eine Vielzahl von Befestigungslöchern 3 mit Gewinden auf. Anstelle der Befestigungslöcher 3 könnte auch ein Schraub-/Gewindekanal in der Befestigungsschiene 2 vorhanden sein.

Der gezeigte erfindungsgemäße Baugruppenträger 1 ist mit mehreren Steckbaugruppen 4 teilweise bestückt, die eine Leiterplatte 5 und eine Frontplatte 6 aufweisen. Die Frontplatten 6 haben an ihrem oberen und unteren Ende jeweils eine Bohrung 7, durch die ein Befestigungselement in eines der Befestigungslöcher 3 geschraubt werden kann. Im Bereich des unteren Endes der Frontplatte 6 ist ein optionales Griffteil angeordnet, mit dem die Steckbaugruppe 4 in ihre Position gebracht werden kann.

An der Hinterkante der Leiterplatte 5 ist eine Steckzunge ausgebildet, der im eingeschobenen Zustand der Steckbaugruppe 4 in dem Baugruppenträger 1 in eine hier nicht dargestellte Steckaufnahme der Back plane 8 (Rückplatine) des Baugruppenträgers 1 eingreift.

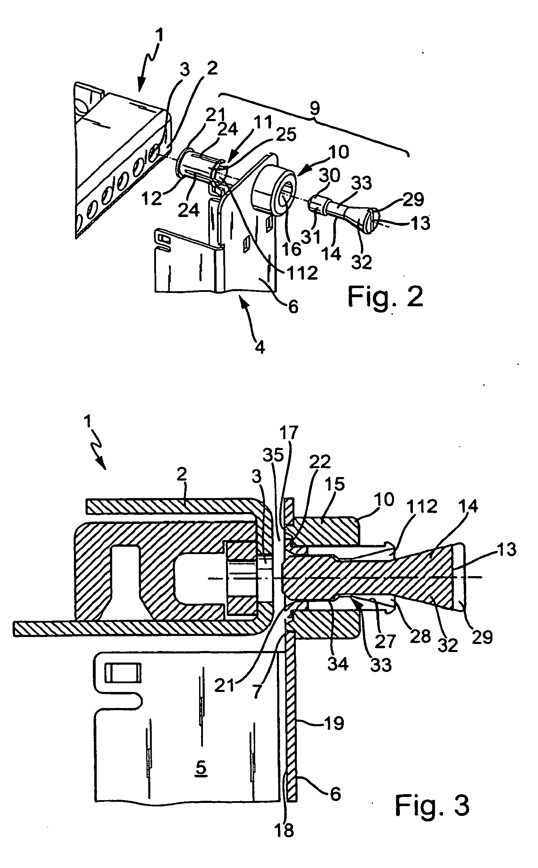

Die Figuren 2 und 3 zeigen die efindungsgemäße Steckbaugruppe 4, die in dem Baugruppenträger 1 mit einer Befestigungsvorrichtung 9 befestigt ist. Die erfindungsgemäße Befestigungsvorrichtung 9 umfasst ein Lagerteil 10, ein Spannteil 11, das als Spreizhülse 12 mit einer Durchgangsbohrung 112 ausgebildet ist, und ein Befestigungselement 13, das in der bevorzugten Ausführungsform eine Kegelschraube 14 ist.

Das Lagerteil 10 ist eine zylindrische Lagerhülse 15 mit einer axialen Bohrung 16. Die Lagerhülse 15 weist an ihrem einen Ende eine Nase 17 (Zentrierbund) auf, die sich in die Bohrung 7 der Frontplatte 6 erstreckt, wenn die Lagerhülse 15 an der Frontplatte 6 befestigt ist. Die Länge der Nase 17 (axiale Dimension) entspricht maximal der Dicke der Frontplatte 6, so dass die Nase 17 bündig mit der Rückseite 18 der Frontplatte 6 abschließt.

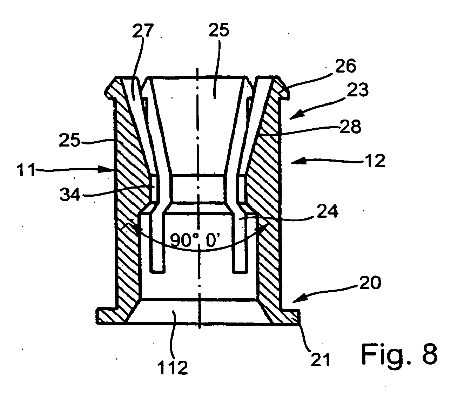

Die in den Figuren 2 und 8 (als Schnittzeichnung) gezeigte Spreizhülse 12 mit ihrer Durchgangsbohrung 112 weist an ihrem einen (ersten) Ende 20 einen Kragen 21 auf, der mit einem Rückschnitt 22 der Lagerhülse 15 derart korrespondiert, dass die in die Lagerhülse 15 eingeschobene Spreizhülse 12 bündig mit der Lagerhülse 15 und der Rückseite 18 der Frontplatte 6 abschließt.

Von einem dem Kragen 21 gegenüberliegenden Ende 23 aus erstrecken sich bevorzugt mehrere Einschnitte 24 in axialer Richtung. Ihre Länge entspricht etwa 80 % der Länge der Spreizhülse 12. Zwischen zwei benachbarten axialen Einschnitten 24 werden Spannzungen 25 gebildet, die als Spreizelemente oder Klemmbacken dienen. An der Außenseite des Endes 23 der Spreizhülse 12 sind Verriegelungsnasen 26 ausgebildet, die sich hakenförmig in Richtung Ende 23 verjüngen. Wird die Spreizhülse 12 von der Rückseite 18 der Frontplatte 6 in die Lagerhülse 15 eingeschoben, so werden die Spannzungen 25 derart zusammengedrückt, dass die Spreizhülse 12 in die Lagerhülse 15 eingeschoben werden kann. Die bevorzugten Verriegelungsnasen 26 an den Spannzungen 25 verhindern ein Herausrutschen oder ein unbeabsichtigtes Herausbewegen des Spannteils 11 aus dem Lagerteil 10.

Die Spreizhülse 12 hat an ihrem Ende 23 bevorzugt an der Innenseite der Durchgangsbohrung 112 eine trichterförmige Aufweitung 27. Sie ist durch eine Abschrägung 28 realisiert, die bevorzugt einen Winkel von höchstens 30 Grad, besonders bevorzugt von höchstens 20 Grad und weiter bevorzugt von höchstens 10 Grad aufweist. In der gezeigten Ausführungsform hat die Aufweitung 27 einen Winkel von ca. 15 Grad. Die Aufweitung 27 bzw. deren Abschrägung 28 korrespondiert mit der Neigung eines kegelförmigen Endes 29 der Kegelschraube 14.

Die Kegelschraube 14 in den Figuren 2 bis 7 hat an ihrem Ende 30 ein Gewinde 31, mit dem sie in die Befestigungslöcher 3 der Befestigungsschiene 2 eingeschraubt werden kann. Bevorzugt weist die Kegelschraube 14 an dem Ende 29 einen konischen Abschnitt 32 auf. In einer bevorzugten Ausführungsform ist zwischen dem Gewinde 31 und dem konischen Abschnitt 32 ein Zwischenabschnitt 33 ausgebildet, dessen Durchmesser bevorzugt geringer ist als der Durchmesser des Gewindestücks 31. Ein mit dem Gewinde 31 korrespondierendes Innengewinde 34 in der Durchgangsbohrung 112 der Spreizhülse 12 (bevorzugterweise an die Aufweitung 27 anschließend) verhindert ein Herausfallen der Kegelschraube 14 aus der Spreizhülse 12.

Die Figuren 3 bis 7 zeigen einen Querschnitt durch den oberen Teil der Steckbaugruppe 4 und der Befestigungsschiene 2 des Baugruppenträgers 1.

Erfindungsgemäß wird zur Befestigung der Steckbaugruppe 4 mit der Frontplatte 6 in dem Baugruppenträger 1 zuerst das Lagerteil 10 an der Frontseite 19 der Frontplatte 6 befestigt. Das Spannteil 11 wird bevorzugt in die Bohrung 16 des Lagerteils 10 von der Rückseite 18 der Frontplatte 6 eingeschoben. Bevorzugt wird das Spannteil 11 an seinem Ende 23, an dem die Einschnitte 24 sind, derart zusammengedrückt, dass es durch die Bohrung 16 des Lagerteils 10 passt. Da das Spannteil 11 bevorzugt länger als das Lagerteil 10 ist, überragt es das Lagerteil 10 in axialer Richtung und ist axial verschiebbar. Der Kragen 21 und die Verriegelungsnasen 26 des Spannteils 11 verhindern ein Herausrutschen aus dem Lagerteil 10. Die Durchgangsbohrung 112 des Spannteils 11 fluchtet mit der Bohrung 16 des Lagerteils 10.

Die Steckbaugruppe 4 mit ihrer Leiterplatte 5 ist in Figur 3 soweit in den Baugruppenträger 1 eingeschoben, dass zwischen der Frontplatte 6 und der Befestigungsschiene 2 ein Spalt 35 entsteht. Die Nase 17 der Lagerhülse 15 schließt bündig mit der Rückseite 18 der Frontplatte 6 ab. Die Spreizhülse 12 ist in der Lagerhülse 15 derart positioniert, dass ihr Kragen 21 an dem korrespondierenden Rückschnitt 22 der Lagerhülse 15 anliegt und bündig mit der Rückseite 18 der Frontplatte 6 abschließt. Das Ende 23 der Spreizhülse 12 steht über die Lagerhülse 15 über. Die Kegelschraube 14 ist in der Spreizhülse 12 derart angeordnet, dass ihr konischer Abschnitt 32 von der Spreizhülse 12 und deren Aufweitung 27 beabstandet ist. Die Kegelschraube 14 ist in die Spreizhülse 12 eingeschoben bzw. eingeschraubt, aber noch nicht in die Befestigungsschiene 2 geschraubt.

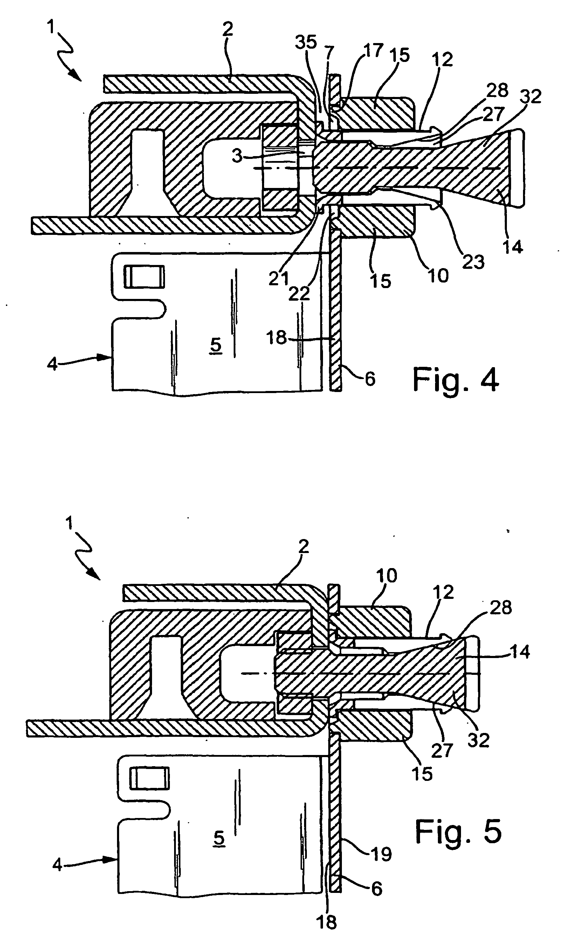

Nach dem Einschieben der Steckbaugruppe 4 in den Baugruppenträger 1 in eine gewünschte Endposition wird im nächsten Schritt das Befestigungselement 13 weiter in Einschubrichtung in das Spannteil 11 eingesteckt (Figur 4), bevor es in der Befestigungsschiene 2 verschraubt wird.

In Figur 4 ist die in dem Lagerteil 10 beweglich gelagerte Spreizhülse 12 soweit in Einschubrichtung verschoben, bis ihr Kragen 21 an der Befestigungsschiene 2 anliegt. Da die Spreizhülse 12 in der Lagerhülse 15 beweglich verschiebbar ist, sind die Frontplatte 6 und die Steckbaugruppe 4 in ihrer Position verblieben.

Sobald der konische Abschnitt 32 des Befestigungselements 13 mit der korrespondierenden Abschrägung 28 der trichterförmigen Aufweitung 27 des Spannteils 11 zusammenwirkt, wird die Spreizhülse 12 quer zur Einschubrichtung derart auseinandergedrückt, dass die Spreizhülse 12 aufgeweitet wird und eine kraftschlüssige Verbindung zwischen dem Spannteil 11 und dem Lagerteil 10 entsteht. Die Spreizhülse 12 wird zwischen der Kegelschraube 14 und der Lagerhülse 15 verklemmt. Die Steckbaugruppe 4 wird in der definierten Position relativ zu dem Baugruppenträger 1 fixiert und bleibt auch während dem Aufbringen der Kraft unverändert, da die auf das Lagerteil 10 ausgeübte Kraft quer zur Einschubrichtung orientiert ist. Ein Verschieben der Steckbaugruppe 4 bzw. der Frontplatte 6 in oder entgegen der Einschubrichtung ist ausgeschlossen.

Hierdurch ergibt sich der Vorteil, dass die Steckbaugruppe 4 mit dem Baugruppenträger 1 durch eine Schraube fixiert werden kann. Damit lässt sich eine zuverlässige und robuste Fixierung der Position der Steckbaugruppe 4 realisieren. Selbst bei hohen Anforderungen an Stöße oder Vibrationen hält die Befestigung zuverlässig. Gleichzeitig wird während der Befestigung mit der Kegelschraube 14 die Steckbaugruppe 4 nicht gegen die Befestigungsschiene 2 des Baugruppenträgers 1 gezogen, sondern bleibt in der gewünschten Position. Ein zwischen der Befestigungsschiene 2 und der Frontplatte 6 der Steckbaugruppe 4 bestehender Spalt 35 bleibt erhalten und unverändert. Kräfte, die in Einschubrichtung auf die Steckbaugruppe 4 wirken, werden verhindert. Somit ist die Gefahr ausgeschlossen, dass es durch die Befestigung zu Beschädigungen oder Zerstörungen der Leiterplatte 5 der Steckbaugruppe 4 oder der Back plane 8 des Baugruppenträgers 1 kommt.

Die Figuren 5 bis 7 zeigen die gesicherte Steckbaugruppe 4, wenn die Kegelschraube 14 in das Befestigungsloch 3 der Befestigungsschiene 2 eingeschraubt ist. Die Figuren 5 bis 7 unterscheiden sich durch die Breite des Spalts 35 zwischen der Frontplatte 6 und der Befestigungsschiene 2.

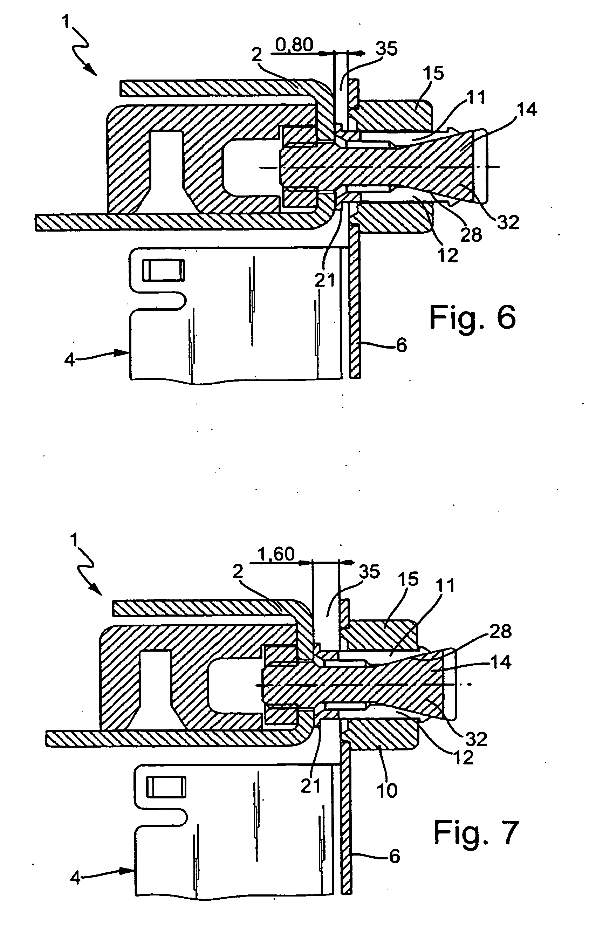

In Figur 5 ist die Steckbaugruppe 4 soweit eingeschoben, dass die Frontplatte 5 an der Befestigungsschiene 2 anliegt. In den Figuren 6 und 7 ist zwischen der Befestigungsschiene 2 und der Frontplatte 6 ein Spalt 35 von 0,8 bzw. 1,6 Millimeter ausgebildet. In dem gesicherten Zustand der Steckbaugruppe 4 liegt in der hier beschriebenen Ausführungsform die Spreizhülse 12 mit ihrem Kragen 21 stets an der Befestigungsschiene 2 an.

## Patentansprüche

1. Elektronische Steckbaugruppe zur Aufnahme in einem Baugruppenträger mit einer Befestigungsschiene, wobei
- die Steckbaugruppe (4) eine Leiterplatte (5), eine Frontplatte (6) und eine Befestigungsvorrichtung (9) einschließt,
- die Befestigungsvorrichtung (9) ein Lagerteil (10), ein Spannteil (11) und ein Befestigungselement (13) umfasst,
**dadurch gekennzeichnet, dass**
- das Lagerteil (10) eine zylindrische Lagerhülse ist, die eine Bohrung (16) aufweist und an der Frontplatte (6) befestigbar ist,
- das Spannteil (11) das Lagerteil (10) in axialer Richtung überragt und in der Bohrung (16) des Lagerteils (10) verschiebbar gelagert ist,
- das Spannteil (11) eine Durchgangsbohrung (112) aufweist,
- das Befestigungselement (13) sich durch eine Durchgangsbohrung (112) des Spannteils (11) erstreckt und in der Durchgangsbohrung (112) beweglich gelagert ist, wenn das Lagerteil (10) an der Frontplatte (6) befestigt und das Spannteil (11) in dem Lagerteil (10) angeordnet ist,
- das Befestigungselement (13) an der Befestigungsschiene (2) des Baugruppenträgers (1) derart befestigbar ist, dass das Befestigungselement (13) kraftschlüssig mit dem Spannteil (11) verbunden wird, dass das Lagerteil (10), das Spannteil (11) und das Befestigungselement (13) zueinander in einer definierten Relativposition fixiert sind und dass die beim Fixieren auftretende Kraft auf das Lagerteil (10) und die Steckbaugruppe (4) quer zur Einschubrichtung der Steckbaugruppe (4) orientiert ist, wobei das Spannteil (11) an der Befestigungsschiene (2) anliegt.

2. Steckbaugruppe nach Anspruch 1, **dadurch gekennzeichnet, dass** das Spannteil (11) in dem Lagerteil (10) derart angeordnet ist, dass ein Herausrutschen des Spannteils (11) aus dem Lagerteil (10) verhindert wird.

3. Steckbaugruppe nach Anspruch 1 oder 2, **dadurch gekennzeichnet, dass** das Lagerteil (10) derart an der Frontplatte (6) befestigt ist, dass das Lagerteil (10) bündig mit der Rückseite (18) der Frontplatte (6) abschließt.

4. Steckbaugruppe nach Anspruch 3, **dadurch gekennzeichnet, dass** sich das Spannteil (11) durch die Bohrung (16) des Lagerteils (10) derart erstreckt, dass das Spannteil (11) bündig mit der Rückseite (18) der Frontplatte (6) abschließt.

5. Steckbaugruppe nach Anspruch 4, **dadurch gekennzeichnet, dass** das Spannteil (11) In einem befestigten Zusland, wenn die Steckbaugruppe in dem Baugruppenträger fixiert ist, an der Befestigungsschiene (2) des Baugruppenträgers (1) anliegt.

6. Steckbaugruppe nach einem der vorhergehenden Ansprüche, **dadurch gekennzeichnet, dass** eine Durchgangsbohrung (112) des Spannteils (11) eine trichterförmige Aufweitung (27) aufweist und das Befestigungselement (13) einen konischen Abschnitt (32) hat, der mit der trichterförmigen Aufweitung (27) des Spannteils (11) korrespondiert.

7. Steckbaugruppe nach einem der vorhergehenden Ansprüche, **dadurch gekennzeichnet, dass** die Steckbaugruppe (4) derart in dem Baugruppenträger (1) in ihrer Position fixiert ist, dass zwischen der Frontplatte (6) der Steckbaugruppe (4) und der Befestigungsschiene (2) des Baugruppenträgers (1) ein Spalt (35) eingehalten ist.

8. Steckbaugruppe nach einem der vorhergehenden Ansprüche, **dadurch gekennzeichnet, dass** das Spannteil (11) wenigstens eine klemmbacke mit Spreizung in zwei oder mehr Richtungen aufweist.

9. Steckbaugruppe nach einem der vorhergehenden Ansprüche, **dadurch gekennzeichnet, dass** das Spannteil (11) eine Hülse (12) ist, an deren einen Ende eine Spannzunge (25) angeordnet ist, die in radialer Richlung bewegbar ist.

10. System nach Anspruch 9, **dadurch gekennzeichnet, dass** die Spannzunge (25) an dem Ende des Spannteils (11) angeordnet sind, an dem die Durchgangsbohrung (112) die trichterförmige Aufweitung (27) aufweist.

11. Steckbaugruppe nach Anspruch 9 oder 10, **dadurch gekennzeichnet, dass** die Spannzunge (25) der Spannhülse (11, 12) federnd ausgebildet ist.

12. Steckbaugruppe nach einem der vorhergehenden Ansprüche, **dadurch gekennzeichnet, dass** das Lagerteil (10) mit der Frontplatte (6) der Steckbaugruppe (4) einstückig verbunden ist.

13. Baugruppenträger mit einer Befestigungsschiene in seinem Frontbereich und einer Steckbaugruppe nach einem der vorhergehenden Ansprüche, **dadurch gekennzeichnet, dass** die Steckbaugruppe (4) in dem Baugruppenträger in einer definierten Position fixierbar ist, ohne dass beim Fixieren Kräfte in Einschubrichtung der Steckbaugruppe (4) ausgeübt werden.

14. Verfahren zur Befestigung einer Steckbaugruppe nach einem der vorhergehenden Ansprüche mit einer Frontplatte an einem Baugruppenträger mit einer Befestigungsschiene mittels einer Befestigungsvorrichtung (9), die ein Lagerteil (10), ein Spannteil (11) und ein Befestigungselement (13) umfasst, **gekennzeichnet durch** die folgenden Schritte:
a) Befestigen des Lagerteils (10) mit einer axialen Bohrung (16) an der Frontseite (19) der Frontplatte (6) der Steckbaugruppe (4),
b) Einstecken des Spannteils (11) in die Bohrung (16) des Lagerteils (10) von der Rückseite (18) der Frontplatte (6) der Steckbaugruppe (4) derart, dass das Spannteil (11) in dem Lagerteil (10) verschiebbar ist und eine Durchgangsbohrung (112) des Spannteils (11) mit der Bohrung (16) des Lagerteils (10) fluchtet,
c) Einschieben der Steckbaugruppe (4) in den Baugruppenträger (1) bis die Steckbaugruppe (4) und ihre Frontplatte (6) in einer definierten Position angeordnet sind,
d) Einstecken des Befestigungselementes (13) in das Spannteil (11),
e) Ausüben einer Kraft **durch** das Befestigungselement (13) auf das Spannteil (11) derart, dass eine kraftschlüssige Verbindung zwischen dem Spannteil (11) und dem Lagerteil (10) erfolgt und dass die Steckbaugruppe (4) mit ihrer Frontplatte (6) in der definierten Position relativ zu dem Baugruppenträger (1) fixiert ist, wobei die auf das Lagerteil (10) ausgeübte Kraft quer zur Einschubrichtung der Steckbaugruppe (4) orientiert ist,
wobei wenigstens die Verfahrensschritte a und b vor dem Verfahrensschritt c ausgeführt werden.

## Claims

1. An electronic plug-in assembly for reception in an assembly carrier with a fastening rail, wherein
- the plug-in assembly (4) includes a printed circuit bored (5), a front plate (6) and a fastening device (9),
- the fastening device (9) includes a bearing member (10), a clamping member (11) and a fastening element (13),
**characterised in that**
- the bearing member (10) is a cylindrical bearing sleeve, which affords a bore (16) and may be fastened to the front plate (6),
- the clamping member (11) extends beyond the bearing member (10) in the axial direction and is slidably mounted in the bore (16) of the bearing member (10),
- the clamping member (11) affords a passage (112),
- the fastening element (13) extends through a passage (112) in the clamping member (11) and is movably mounted in the passage (112) when the bearing member (10) is fastened to the front plate (6) and the clamping member (11) is disposed in the bearing member (10),
- the fastening element (13) is fastenable to the fastening rail (2) of the assembly carrier (1) such that the fastening element (13) is frictionally locked to the clamping member (11), that the bearing member (10), the clamping member (11) and the fastening element (13) are fixed relative to one another in defined relative positions and that the force arising during the fixing process on the bearing member (10) and the plug-in assembly (4) is orientated transversely to the direction of insertion of the plug-in assembly (4), wherein the clamping member (11) engages the fastening rail (2).

2. A plug-in assembly as claimed in claim 1, **characterised in that** the clamping member (11) is arranged in the bearing member (10) such that sliding of the clamping member (11) out of the bearing member (10) is prevented.

3. A plug-in assembly as claimed in claim 1 or 2, **characterised in that** the bearing member (10) is fastened to the front plate (6) such that the bearing member (10) terminates flush with the rear surface (18) of the front plate (6).

4. A plug-in assembly as claimed in claim 3, **characterised in that** the clamping member (11) extends through the bore (16) in the bearing member (10) such that the clamping member (11) terminates flush with the rear surface (18) of the front plate (6).

5. A plug-in assembly as claimed in claim 4, **characterised in that** the clamping member (11) engages the fastening rail (2) of the assembly carrier (1) in a fastened state, when the plug-in assembly is fixed in position in the assembly carrier.

6. A plug-in assembly as claimed in one of the preceding claims, **characterised in that** a passage (112) in the clamping member (11) has a funnel-shaped enlargement (27) and the fastening element (13) has a conical section (32), which corresponds to the funnel-shaped enlargement (27) of the clamping member (11).

7. A plug-in assembly as claimed in one of the preceding claims, **characterised in that** the plug-in assembly (4) is fixed in its position in the assembly carrier (1) such that a gap (35) is maintained between the front plate (6) of the plug-in assembly (4) and the fastening rail (2) of the assembly carrier (1).

8. A plug-in assembly as claimed in one of the preceding claims, **characterised in that** the clamping member (11) includes at least one clamping jaw with a spread angle in two or more directions.

9. A plug-in assembly as claimed in one of the preceding claims, **characterised in that** the clamping member (11) is a sleeve (12), arranged on one end of which is a clamping tongue (25), which is movable in the radial direction.

10. A system as claimed in claim 9, **characterised in that** the clamping tongue (25) is arranged at the end of the clamping member (11) at which the passage (112) affords the funnel-shaped enlargement.

11. A plug-in assembly as claimed in claim 9 or 10, **characterised in that** the clamping tongue (25) of the clamping sleeve (11, 12) is resilient.

12. A plug-in assembly as claimed in one of the preceding claims, **characterised in that** the bearing member (10) is integrally connected to the front plate (6) of the plug-in assembly (4).

13. An assembly carrier with a fastening rail in its front region and plug-in assembly as claimed in one of the preceding claims, **characterised in that** the plug-in assembly (4) is fixable in a defined position within the assembly carrier without forces being exerted in the insertion direction of the plug-in-assembly (4) during the fixing process.

14. A method of fastening a plug-in assembly as claimed in one of the preceding claims with a front plate to an assembly carrier with a fastening rail by means of a fastening device (9), which includes a bearing member (10), a clamping member (11) and a fastening element (13), **characterised by** the following steps:
a) fastening the bearing member (10) with an axial bore (16) to the front surface (19) of the front plate (6) of the plug-in assembly (4).
b) inserting the clamping member (11) in the bore (16) in the bearing member (10) from the rear side (18) of the front plate (6) of the plug-in assembly (4) such that the clamping member (11) is movable in the bearing member (10) and a passage (112) in the clamping member (11) is in alignment with the bore (16) in the bearing member (10),
c) sliding the plug-in assembly (4) into the assembly carrier (1) until the plug-in assembly (4) and its front plate (6) are disposed in a defined position,
d) inserting the fastening element (13) into the clamping member (11),
e) exerting a force by the fastening element (13) on to the clamping member (11) such that a frictional connection occurs between the clamping member (11) and the bearing member (10) and that the plug-in assembly (4) with its front plate (6) is fixed in the defined position relative to the assembly carrier (1), wherein the force exerted on the bearing member (10) is orientated transversely to the direction of insertion of the plug-in assembly (4),
wherein at least the method steps a) and b) are performed before the method step c).

## Revendications

1. Module électronique enfichable destiné à être reçu dans un support de modules comprenant un rail de fixation,
- le module enfichable (4) comprenant une carte imprimée (5), une plaque avant (6) et un dispositif de fixation (9),
- le dispositif de fixation (9) comprenant une pièce de palier (10), une pièce de serrage (11) et un élément de fixation (13),
**caractérisé en ce que**
- la pièce de palier (10) est une douille de palier cylindrique qui est pourvue d'un alésage (18) et peut être fixée sur la plaque avant (6),
- la pièce de serrage (11) dépasse de la pièce de palier (10) dans la direction axiale et est logée dans l'alésage (16) de la pièce de palier (10) d'une manière permettant un déplacement,
- la pièce de serrage (11) est pourvue d'un alésage de passage (112),
- l'élément de fixation (13) s'étend à travers un alésage de passage (112) de la pièce de serrage (11) et est logé de manière mobile dans l'alésage de passage (112) lorsque la pièce de palier (10) est fixée sur la plaque avant (6) et que la pièce de serrage (11) est placée dans la pièce de palier (10),
- l'élément de fixation (13) peut être fixé sur le rail de fixation (2) du support de modules (1) de telle sorte que l'élément de fixation (13) est relié par adhérence à la pièce de serrage (11), que la pièce de palier (10), la pièce de serrage (11) et l'élément de fixation (13) sont fixés dans une position relative définie les uns par rapport aux autres et que la force exercée sur la pièce de palier (10) et le module enfichable (4) lors de la fixation est orientée perpendiculairement à la direction d'introduction du module enfichable (4), la pièce de serrage (11) étant en contact avec le rail de fixation (2).

2. Module enfichable selon la revendication 1, **caractérisé en ce que** la pièce de serrage (11) est placée dans la pièce de palier (10) de telle sorte qu'il est évité que la pièce de serrage (11) ressorte en glissant de la pièce de palier (10).

3. Module enfichable selon la revendication 1 ou 2, **caractérisé en ce que** la pièce de palier (10) est fixée sur la plaque avant (6) de telle sorte que la pièce de palier (10) affleure dans le même plan que le côté postérieur (18) de la plaque avant (6).

4. Module enfichable selon la revendication 3, **caractérisé en ce que** la pièce de serrage (11) s'étend à travers l'alésage (16) de la pièce de palier (10) de telle sorte que la pièce de serrage (11) affleure dans le même plan que le côté postérieur (18) de la plaque avant (6).

5. Module enfichable selon la revendication 4, **caractérisé en ce que** la pièce de serrage (11) à l'état fixé, lorsque le module enfichable est fixé dans le support de modules, est en contact avec le rail de fixation (2) du support de modules (1).

6. Module enfichable selon l'une des revendications précédentes, **caractérisé en ce qu'**un alésage de passage (112) de la pièce de serrage (11) présente un évasement en forme d'entonnoir (27) et l'élément de fixation (13) comprend une partie conique (32) qui correspond à l'évasement en forme d'entonnoir (27) de la pièce de serrage (11).

7. Module enfichable selon l'une des revendications précédentes, **caractérisé en ce que** le module enfichable (4) est fixé en position dans le support de modules (1) de telle sorte qu'une fente (35) est ménagée entre la plaque avant (6) du module enfichable (4) et le rail de fixation (2) du support de modules (1).

8. Module enfichable selon l'une des revendications précédentes, **caractérisé en ce que** la pièce de serrage (11) comprend au moins une mâchoire de serrage qui s'écarte dans deux, ou plus de deux, directions.

9. Module enfichable selon l'une des revendications précédentes, **caractérisé en ce que** la pièce de serrage (11) est une douille (12) à une extrémité de laquelle se trouve une languette de serrage (25) qui est mobile dans la direction radiale.

10. Système selon la revendication 9, **caractérisé en ce que** la languette de serrage (25) est située à l'extrémité de la pièce de serrage (11) où l'alésage de passage (112) présente l'évasement en forme d'entonnoir (27).

11. Module enfichable selon la revendication 9 au 10, **caractérisé en ce que** la languette de serrage (25) de la douille de serrage (11, 12) est exécutée de manière élastique.

12. Module enfichable selon l'une des revendications précédentes, **caractérisé en ce que** la pièce de palier (10) est solidaire de la plaque avant (6) du module enfichable (4).

13. Support de modules dont la zone antérieure est pourvue d'un rail de fixation, et avec un module enfichable selon l'une des revendications précédentes, **caractérisé en ce que** le module enfichable (4) peut être fixé dans une position définie dans le support de modules sans que des forces soient exercées dans la direction d'introduction du module enfichable (4) lors de la fixation.

14. Procédé de fixation d'un module enfichable selon l'une des revendications précédentes avec une plaque avant sur un support de modules pourvu d'un rail de fixation au moyen d'un dispositif de fixation (9) qui comprend une pièce de palier (10) une pièce de serrage (11) et un élément de fixation (13), **caractérisé par** les étapes suivantes :
a) fixation de la partie de palier (10) pourvue d'un alésage axial (16) sur le côté antérieur (19) de la plaque avant (6) du module enfichable (4),
b) insertion de la pièce de serrage (11) dans l'alésage (16) de la pièce de palier (10) par le côté postérieur (18) de la plaque avant (6) du module enfichable (4) de telle sorte que la pièce de serrage (11) peut se déplacer dans la partie de palier (10) et qu'un alésage de passage (112) de la pièce de serrage (11) s'aligne avec l'alésage (16) de la pièce de palier (10),
c) introduction du module enfichable (4) dans le support de modules (1) jusqu'à ce que le module enfichable (4) et sa plaque avant (6) se trouvent dans une position définie,
d) insertion de l'élément de fixation (13) dans la pièce de serrage (11),
e) exercice d'une force sur la pièce de serrage (11) grâce à l'élément de fixation (13) de telle sorte qu'une liaison par adhérence est obtenue entre la pièce de serrage (11) et la pièce de palier (10) et que le module enfichable (4), avec sa plaque avant (6), est fixé dans la position définie par rapport au support de modules (1), la force exercée sur la pièce de palier (10) étant perpendiculaire à la direction d'introduction du module enfichable (4),
au moins les étapes a et b du procédé étant exécutées avant l'étape c.
